# EUROPEAN PATENT APPLICATION

(11) **EP 0 776 039 A2**
(43) Date of publication of application: **28.05.1997**
(21) Application number: 96308408.2
(22) Date of filing: 20.11.1996
(51) Int. Cl.: H01L 23/31

(54) **Improvements in or relating to semiconductor packages**

(30) Priority: 21.11.1995 US 7409
(71) Applicant: TEXAS INSTRUMENTS INCORPORATED, Dallas Texas 75265 (US)
(72) Inventor: Schroen, Walter H., Dallas, Texas 75230 (US)
(74) Representative: Darby, David Thomas

(57) **Abstract**

A method of fabricating a semiconductor package and the package. The method comprises the steps of providing a tool (41) for positioning a lead frame (45) relative to a semiconductor chip (21) with the lead frame (45) spaced from the chip (21). A semiconductor chip (21) having a surface containing electronic components thereon and having a thickness in a direction normal to that surface substantially less than the length and width dimension of the chip (21) is disposed on the tool (41). A lead frame (45) is disposed on the tool (41) having a base portion and leads extending from the base portion and spaced from the chip (21), the thickness dimension of the lead frame (45) from the base portion to the leads being no greater than the thickness of the chip (21). Wires are bonded between the leads and the chip and the chip, wires and a portion of the lead frame are encapsulated. The lead frame (45) is disposed on the tool (41) within a volume having the chip surface as one surface thereof and the surface of the chip opposing the one surface as an opposing surface thereof. The wires are sufficiently rigid to prevent movement of the lead frame out of the volume.

## Description

### BACKGROUND OF THE INVENTION

### FIELD OF THE INVENTION

This invention relates to a thin plastic encapsulated semiconductor package and to a method of fabrication thereof.

### BRIEF DESCRIPTION OF THE PRIOR ART

In the fabrication of semiconductor devices, a semiconductor chip is generally secured to a metallic carrier which is part of a lead frame. Wires are bonded between pads on the semiconductor chip and the lead frame leads. The chip, wires and part of the lead frame leads are then encapsulated, generally in plastic, generally by a molding process, with the leads extending externally of the encapsulant. The result is a package having a thickness which is determined by the thickness of each of the metallic carrier and the chip thereon, the distance from the top of the chip to the top of the loop of the wires including a small margin for errors and any additional thickness due to the encapsulant.

With the continued miniaturization of electronic devices, such as, for example, lap top computers, cellular telephones and the like, it is essential that the semiconductor packages be made thinner than in the past. The obvious ways of achieving this goal are not always available and/or do not provide the amount of package width reduction required. While the metallic carrier can be reduced in thickness, such reduction makes the carrier difficult to handle, so this approach is not generally available. The same problem exists when making the semiconductor chip thinner. For example, silicon, which is the most widely used semiconductor material used for semiconductor device fabrication, is very brittle and often will break during processing if too thin. To thin the silicon, generally, the rear surface of the silicon chip is back ground after processing and before encapsulation, however, this backgrinding is generally limited to no less than about a 10 to 12 mil silicon thickness to minimize breakage of a now more valuable fabricated device which must still undergo packaging and possibly other processing steps. Further backgrinding has been found to result in unacceptable risk of wafer breakage. The backgrinding step also presents the problem of introducing contaminants into the wafer fabrication environment which can cause defects in the devices being fabricated. It is well known that semiconductor devices must be fabricated in a very clean atmosphere because even very small particles of fractions of microns in diameter can cause problems if they land on a device being fabricated, such as, for example, short circuits, in view of the dimensions of the components being fabricated. Wire looping and/or packaging may possibly be improved in the future as a part of the industry effort to minimize semiconductor device package thickness and these processing steps are not considered herein.

### SUMMARY OF THE INVENTION

In accordance with the present invention, the above described problem is minimized and there is provided a packaging arangement for a semiconductor device that produces a package which is thinner than comparable packages of the prior art, yet retains the beneficial properties resulting from a relatively thick chip and a relatively thick lead frame.

Briefly, this is accomplished by eliminating the metallic carrier from the back side of the chip and disposing the lead frame within a volume having an upper surface which includes the component containing surface of the chip and a lower surface which includes the surface of the chip opposing the component containing surface.

The above is accomplished by providing a tool for positioning a lead frame relative to a semiconductor chip with the lead frame spaced from the chip. A semiconductor chip having a surface containing electronic components thereon and having a thickness in a direction normal to that surface substantially less than the length and width dimension of the chip is disposed on the tool. A lead frame is disposed on the tool having a base portion and leads extending from the base portion and spaced from the chip, the thickness dimension of the lead frame from the base portion to the leads being no greater than the thickness of the chip. Wires are bonded between the leads and the chip; finally the chip, wires and a portion of the lead frame are encapsulated. The lead frame is disposed on the tool within a volume having the chip surface as one surface thereof and the surface of the chip opposing the one surface as an opposing surface thereof. The wires are sufficiently rigid to prevent movement of the lead frame out of the volume.

### BRIEF DESCRIPTION OF THE DRAWINGS

The present invention will now be further described, by way of example, with reference to illustrated embodiments of the accompanying drawings;
FIGURE 1 is a schematic diagram of a 0.5 mm thick semiconductor device and package fabricated using prior art fabrication techniques;
FIGURE 2 is a schematic diagram of a 0.5 mm thick semiconductor device and package fabricated in accordance with the present invention;
FIGURE 3a is a top view of a tool for use in accordance with the present invention with a lead frame strip disposed thereon; and
FIGURE 3b is a view taken along the line 3b-3b of FIGURE 3a.

### DESCRIPTION OF THE PREFERRED EMBODIMENT

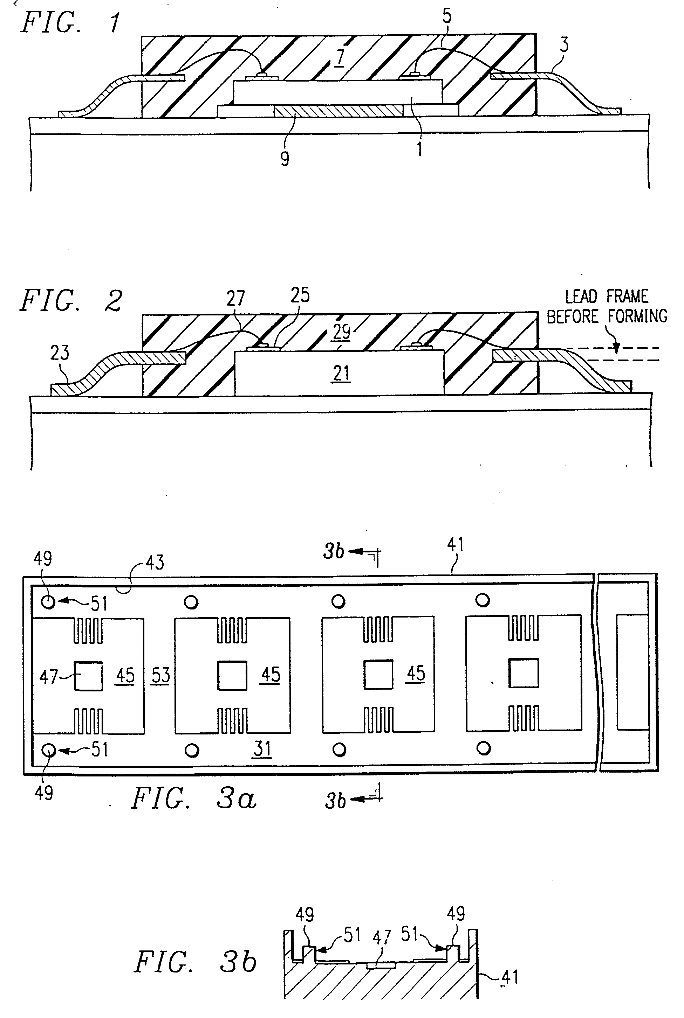

While 1.0 mm (40 mils) thick plastic semiconductor device packages are presently being fabricated, it is desired to fabricate such packages having a thickness of about 0.5 mm (20 mils). A schematic example of such a 0.5 mm package which can be fabricated by prior art techniques is shown in FIGURE 1. The package includes a silicon wafer 1 which has been ground back to 6 mils. Wafers with such dimensions are very difficult to provide when they also have diameters of 6, 8 or 12 inches, the sizes of economically viable wafers in the present state of the art. The lead frame 3 is generally copper with or without additional plating (Ni, Pd, etc.) and is reduced to a thickness of 3 to 4 mils. The wire 5, which can be gold, copper, aluminum, etc. is looped and requires 4 to 5 mils loop height. This leaves only about 3 mils of plastic 7 under the chip and above the top of the wire loop. Problems with such a package arise not only from the thin wafer and lead frame as discussed above, but, in addition, the plastic 7 will exert little force to hold the package together and there will be insufficient thermal performance (i.e, heat dissipation). In regions where the lead frame is under the pad 9 there may be no plastic under the copper and stresses will be aggravated. It is therefore apparent that an embodiment of the type demonstrated in FIGURE 1 is not a viable commercial approach to providing a semiconductor package having a thickness of about 0.5 mm in accordance with the present state of the art. Accordingly, an alternative approach is required.

Referring now to FIGURE 2, there is shown a semiconductor package in accordance with the present invention. The package includes a chip 21 having a thickness dimension of about 11 mils, the same as is generally used in semiconductor device fabrication, thereby minimizing the problems of having a thinner wafer as discussed hereinabove. Also, the step of backgrinding to reach a thickness of 6 mils is eliminated, thereby saving the cost of this step and minimizing processing contamination as discussed above. The availability of the additional silicon, when the chip is silicon, provides a heat spreader/heat sink, reducing the cost of the leadframe and eliminating the cost/time of a die attach operation. The back side of the chip 21 can be at the surface of the package, thereby providing direct contact to additional outside heat sinking.

The leadframe 23 has no chip pad and can lie entirely within the thickness dimension of the chip, thereby allowing conventional metal thicknesses to be used. The lead frame 23 can be supported by "blocks" or other supports during the bonding operation as is discussed hereinbelow.

Bonding is traditional low-loop bonding with the lead frame 23 and pads 25 on the chip 21 and has a height or thickness of about 4 to about 6 mils (as long as pitch permits). Consequently, ball and stitch bonding is similar to and no more difficult than in the prior art. Another preferred type of bonding is ribbon-bonding (Al, Cu), resulting in high strength and robustness. Ball pitch may be lower than 4 mils and approach 2 mils. If Cu wire is used for bonding, it can be selected thin (for extra small balls) or thick (1.2 to 1.5 mils) in order to reduce resistance and inductance. At any rate, the stiffness of Cu will add robustness to the package. The ball size can still be maintained small by appropriate flame-off. The property required of the wire 27 is that it be sufficiently rigid to maintain the lead frame and the chip substantially in the same relationship after wire bonding as it was before wire bonding, namely both being essentially in the same plane. Plastic encapsulation then takes place in standard manner.

To fabricate a semiconductor device in accordance with the present invention, with reference to FIGURES 3a and 3b, a tool 41 is provided for receiving strip 43 of lead frames 45, the tool having an indent 47 located at the center portion of each lead frame and a pair of upwardly extending fingers 49 associated with each lead frame and designed to engage holes 51 in the strip 45 to properly align strip and each lead frame on the tool. The indent 47 is of small dimension relative to the thickness dimension of the chip, the amount of indent merely being sufficient to retain the chip therein through the wire bonding fabrication step and maintain the lead frame within the thickness dimension of the chip. The chip 21 is placed in the indent 47 and wires 27 are then bonded in a manner as described above, by wire ball bonding, or, preferably, by ribbon bonding techniques, between the leads 23 of the lead frames 45 and bond pads 25 on the chip 21. The wires are sufficiently rigid to maintain the planarity between the chip 21 and the lead frame leads 23, which planarity is provided by the tool 41. The rigidity of the wires is enhanced by ribbon bonding and/or by tailoring of the wire composition for the amount of rigidity required. The devices can then be severed along the region 53 between lead frames and then encapsulated with plastic 29 or the entire strip can be removed from the tool 41 with all of the devices being simultaneously encapsulated. The strip edge portions 31 are then removed and the leads of the lead frame are cut, if necessary, and bent, if necessary, to provide the completed device. The result is a thin package which can be provided with a thickness of 0.5 mm, yet still retain a thick chip and a thick lead frame, thereby providing the benefits of such structure.

Though the invention has been described with respect to a specific preferred embodiment thereof, many variations and modifications will immediately become apparent to those skilled in the art.

## Claims

1. A packaging arrangement for a semiconductor device which comprising:
a semiconductor chip having a surface containing electronic components thereon, the thickness of said chip being less than length and width dimensions thereof;
a lead frame including a base portion having leads extending therefrom, said lead frame being spaced from said chip and having a thickness from said base portion to said leads no greater than said thickness of said chip.

2. The arrangement as claimed in Claim 1, wherein said lead frame is disposed within a volume containing said chip.

3. The arrangement as claimed in Claim 2, wherein said wires are sufficiently rigid to prevent movement of said lead frame out of said volume during fabrication of said package.

4. The arrangement as claimed in any preceding claim further comprising;
wires bonded between said leads and said electronic components; and
an encapsulant encapsulating said chip, said wires and a portion of said lead frame.

5. A method for fabricating a semiconductor package which comprises the steps of:
providing a tool for positioning a lead frame relative to a semiconductor chip with said lead frame spaced from said chip;
disposing on said tool a semiconductor chip having a surface containing electronic components thereon, the thickness of said chip being less than the length and width dimensions thereof;
disposing on said tool a lead frame having a base portion and leads extending from said base portion, said lead frame being spaced from said chip, the thickness dimension of said lead frame from said base portion to said leads being no greater than said thickness of said chip; and
bonding wires between said leads and said electronic components.

6. The method as claimed in Claim 5, wherein said step of disposing said lead frame on said tool comprises disposing the lead frame such that the lead frame is disposed on said tool within a volume containing said chip.

7. The method as claimed in Claim 6, wherein said step of bonding said wires comprises bonding wires that are sufficiently rigid to prevent movement of said lead frame out of said volume during fabrication of said package.

8. The method as claimed in any of Claims 5 to 7, further comprising;
encapsulating said chip, said wires and a portion of said lead frame.

9. A positioning tool for use in the method of any of Claims 5 to 8.
